Europäisches Patentamt

European Patent Office

Office européen des brevets

(11) Publication number: **0 180 025**
A2

# EUROPEAN PATENT APPLICATION

(21) Application number: **85111807.5**

(22) Date of filing: **18.09.85**

(51) Int. Cl.⁴: **H 01 L 27/06**, H 01 L 29/52

(30) Priority: **19.09.84 JP 196232/84**

(43) Date of publication of application: **07.05.86**
Bulletin 86/19

(84) Designated Contracting States: **CH DE FR GB IT LI NL SE**

(71) Applicant: **HITACHI, LTD., 6, Kanda Surugadai 4-chome Chiyoda-ku, Tokyo 100 (JP)**

(72) Inventor: **Yasuda, Yasumichi, 1-10-3, Ohnuma-cho, Hitachi-shi Ibaraki-ken (JP)**
Inventor: **Tanaka, Tomoyuki, 6-5-5, Ohmika-cho, Hitachi-shi Ibaraki-ken (JP)**
Inventor: **Nagano, Takahiro, 7-10-10, Kanesawa-cho, Hitachi-shi Ibaraki-ken (JP)**
Inventor: **Yatsuo, Tsutomu, 2-28-7, Mizuki-cho, Hitachi-shi Ibaraki-ken (JP)**

(74) Representative: **Patentanwälte Beetz sen. - Beetz jun. Timpe - Siegfried - Schmitt-Fumian, Steinsdorfstrasse 10, D-8000 München 22 (DE)**

(54) **Semiconductor device comprising a bipolar transistor and a MOSFET.**

(57) The present invention relates to a semiconductor device having complicated bipolar transistor and MOSFET. In an equivalent circuit of this semiconductor device, MOSFET (3) is connected between the base (33) and emitter (34) of the bipolar transistor (1). The bipolar transistor (1) is a vertical type transistor, and MOSFET (3) a lateral type transistor. The MOSFET (3) is formed on a base (33) surface on the side of one main surface on which the emitter (34) of the bipolar transistor (1) is exposed, in such a manner that the MOSFET (3) is substantially opposed to the emitter (34).

Title of the Invention:

SEMICONDUCTOR DEVICE HAVING COMPLICATED BIPOLAR

TRANSISTOR AND MOSFET

(Field of Utilization of the Invention)

This invention relates to a semiconductor device provided with a bipolar transistor, and a circuit having a MOSFET which is connected between a base and an emitter of the bipolar transistor.

(Background of the Invention)

In a semiconductor device, such as a bipolar transistor used in an electric power switching circuit, the voltage resistance and ON-resistance are undoubtedly important, and the switching characteristics above all.

Owing to the improvement of micro-processing techniques based on a photoetching method which has supported the development of IC's, a short-channel MOS transistor has come into existence in recent years, and this transistor is being developed as an electric power switching element utilizing the unipolar high speed and having a low ON-resistance.

A bipolar transistor is advantageous in comparison with the above-mentioned MOS transistor (MOSFET) in that it is originally capable of reducing its ON-resistance to a low level. When a MOSFET is used to carry out a switching operation, its base is excessively driven, and

- 2 -

it is necessary to obtain the carrier accumulating effect. This causes the displaying of the switching characteristics, especially, the coming of the turn-off time to be delayed. Therefore, when the early turn-off characteristics are required, a circuit for extracting carriers accumulated in the base is additionally provided.

Fig. la shows an example of a bipolar transistor circuit having the improved turn-off characteristics. Reference numeral 1 denotes a bipolar transistor, and 2 a resistor connected between the base and emitter. This resistor 2 has the function of bypassing, during a turn-off operation of the transistor 1, the carriers, which accumulated in the base, to the emitter to reduce the turn-off time. Accordingly, the smaller the value of the resistor 2 is, the shorter the turn-off time becomes. However, when transistor 1 is turned off or in the normal ON-state, the electric driving power at the base increases since the resistor 2 forms a bypass passage between the base and emitter. Therefore, the value of the resistor 2 should ideally be infinitely large while the transistor 1 is on, and the resistor 2 should be short-circuited while the transistor 1 is off.

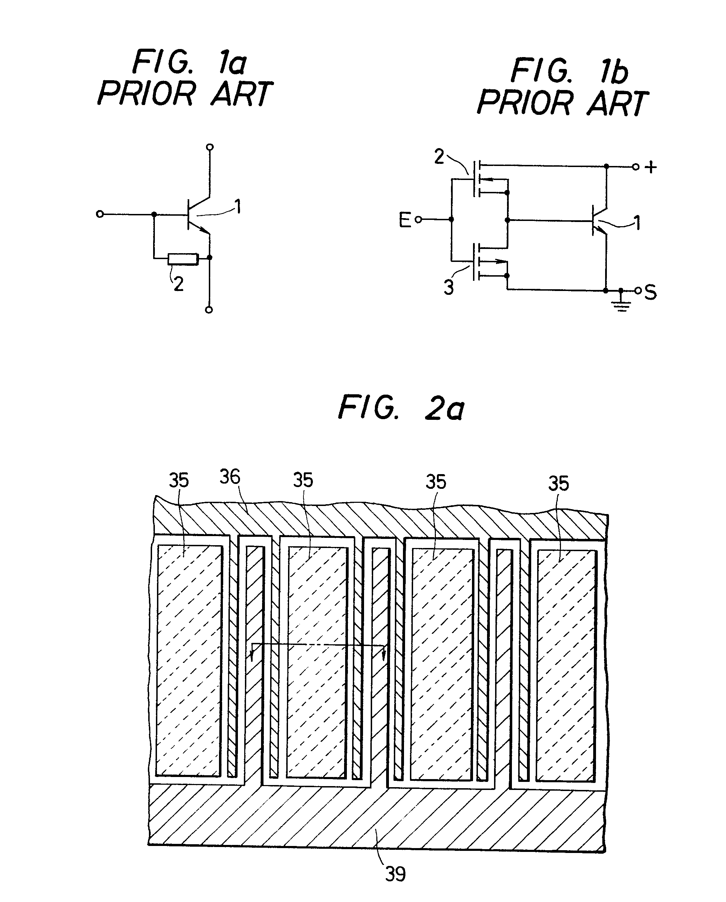

Namely, it is desirable that the resistor consists of a variable resistor. Japanese Patent Laid-Open No. 183067/1982 discloses a semiconductor device of the construction shown in, for example Fig. 1b. In this semiconductor device, a transistor 1 is parallel-connected directly to an emitter-base junction of a third transistor 3, which is an auxiliary transistor (p-channel transistor in this example) with respect to a second conductor type transistor 2, and which consists of an enhancement type insulating gate field-effect transistor, and the gate electrodes of the second and third transistors 2, 3 are thereby connected to each other. In order to turn on the transistor 1, the MOSFET switch 3 is turned off. Consequently, the bypass resistance between the emitter and base becomes infinitely high, and the bipolar transistor 1 can be operated with a high efficiency. While the transistor 1 is being turned off and while it is in the OFF-state, the MOSFET switch 3 is turned on. As a result, the circuit is closed between the emitter and based, and the carriers accumulated in the base are removed rapidly. Thus, the turn-off delay time is reduced and the voltage resistance between the collector and emitter during the OFF-state increases at the same time.

. In these conventional examples, turn-off time is reduced and compared with that in a bipolar transistor but the concentration of an electric current during a turn-off period, which occurs in a bipolar transistor, is

0180025

- 4 -

not eliminated. Accordingly, thermal destruction
sometimes occurs.

(Summary of the Invention)

An object of the present invention is to provide
a semiconductor device, in which a MOSFET switch is
connected between the base and emitter of a bipolar
transistor to obtain a high voltage resistance, a low
ON-resistance and high-speed switching characteristics
and to prevent the concentration of an electric current
during the turn-off period.

Another object of the present invention is to provide
a miniaturized bipolar transistor having a complicated
MOSFET.

The characteristics of the present invention
reside in a semiconductor device, in which a bipolar
transistor and a MOSFET are formed in a complicated
manner on a semiconductor substrate with the source drain
of the MOSFET connected between the base and emitter of
the bipolar transistor, comprising a lateral type of
MOSFET provided near and substantially in opposition to
the emitter of a vertical type of bipolar transistor.
In the semiconductor device thus constructed, the MOSFET
is turned on when the bipolar transistor is turned off,
and an electric current due to the carriers accumulated
excessively in a base-collector region in the bipolar transistor is extracted uniformly from the whole of the periphery of the emitter. Consequently, the resistance to the thermal destruction which occurs due to the concentration of electric current.

Brief Description of the Drawings:

Fig. 1a illustrates a conventional transistor circuit;

Fig. 1b illustrates another conventional transistor circuit;

Fig. 2a is a partial plan view of an embodiment of the semiconductor device according to the present invention;

Fig. 2b is an enlarged vertical section taken along the line A-A in Fig. 2a of the semiconductor device;

Fig. 2c is an equivalent circuit diagram of the semiconductor device of Figs. 2a and 2b;

Fig. 3a is a partial plan view of another embodiment of the semiconductor device according to the present invention;

Fig. 3b is a vertical section taken along the line B-B in Fig. 3a of the semiconductor device; and

Figs. 4-7 are partial plan views of various further embodiments of the semiconductor device according to the present invention.

- 6 -

(Embodiments of the Invention)

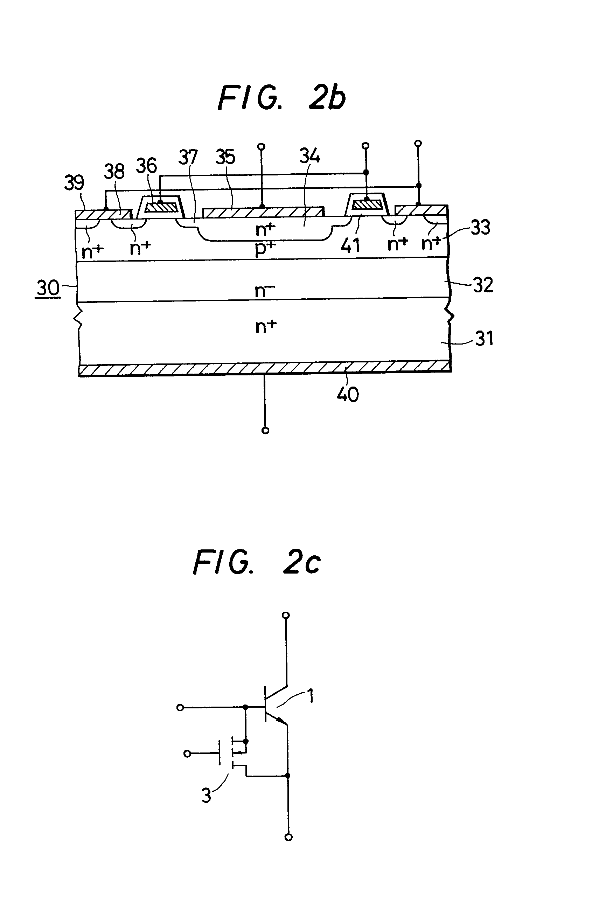

Figs. 2a and 2b show a part of the semiconductor device according to the present invention, and its equivalent circuit is shown in Fig. 2c.

Referring to Fig. 2a and 2b, reference numeral 30 denotes a semiconductor substrate, 31 a $n^+$ type collector layer, 32 a $n^-$ type collector layer, 33 a $p^+$ type base layer, 34 a $n^+$ type emitter layer, 35 an emitter electrode in ohmic contact with the emitter layer 34, 36 a gate of MOSFET connected between the base and emitter of a bipolar transistor and provided on the silicon substrate 30 via a $SiO_2$ film 41, 37 a $n^+$ drain layer, and 38 a $n^+$ source layer. The symbols $+$ and $-$ added to the letters $p$ and $n$ which indicate the conductor types, represent high and low impurity concentrations by which the conductor types are determined. The drain 37 of MOSFET is connected internally to the emitter 34 of the bipolar transistor. The source 38 is provided in the region of the base 33, and in ohmic contact with a base electrode 39 which is in ohmic contact with the base layer 33.

The gate electrode 36 is provided on both sides of the narrow emitter layer 34 so as to extend longitudinally along the layer. Therefore, the MOSFET substantially surrounds the emitter layer 34 of the bipolar transistor. In Fig. 2a, which is a plan view of an embodiment of the present invention, each electrode is hatched so as to make the embodiment understood easily. The emitter layer 34 is provided in a divided manner on a main outer surface of the semiconductor substrate. A MOSFET is provided in opposition to each emitter layer so that the MOSFET surrounds the emitter layer. The bipolar transistor has a three-layer vertical npn structure, and the MOSFET a lateral type of n-channel MOS structure. To turn on the transistor, an ON-signal is applied to the base electrode 39, and, to turn off the transistor, an OFF-signal is applied to the gate electrode 36. As a result, a n-channel is formed in a p-layer which is under the gate electrode 36 and between the source and drain, and the excess carriers in the p-base layer 33 are extracted and put into the emitter layer 34.

MOSFET's are provided on both sides of the emitter of the bipolar transistor. Moreover, a MOSFET is also provided along the rectangular emitter. Accordingly, the rate of extraction of carriers per unit length of the emitter is equal along the lengthwise direction of the rectangular emitter. This enables the carriers to be extinguished uniformly, and prevents the occurrence of the concentration of electric current.

If the semiconductor device is formed in this manner, in which the MOSFET is provided in the base region with the drain connected to the emitter, the carriers stored in the base are bypassed uniformly and rapidly during a turn-off period. Consequently, the turn-off delay time is reduced, and the current distribution in the emitter becomes uniform, the destruction resistance during the turn-off period being also improved. Especially, in this embodiment, MOSFET si formed by utilizing a base region of a conventional bipolar transistor, and, therefore, no additional space is required.

In such an arrangement, phosphorus and arsenic ions were injected into a base region of a bipolar transistor having a base layer 35 of 5μm in thickness and an emitter layer 34 of 1μm in thickness, which was formed on a silicon monocrystal substrate of 35μm in thickness having a specific resistance of 20Ωcm in its $n^-$ collector layer 32, to experimentally form a MOSFET-complicated type bipolar transistor having drain and source of 0.2μm in thickness. It was ascertained that this bipolar transistor had a ON-state direct current amplification factor of 200, a collector and emitter breaking voltage of 600V, an emitter current density at an ON-voltage of 2V of 80A/$Cm^2$ and a turn-off time of 0.5μs.

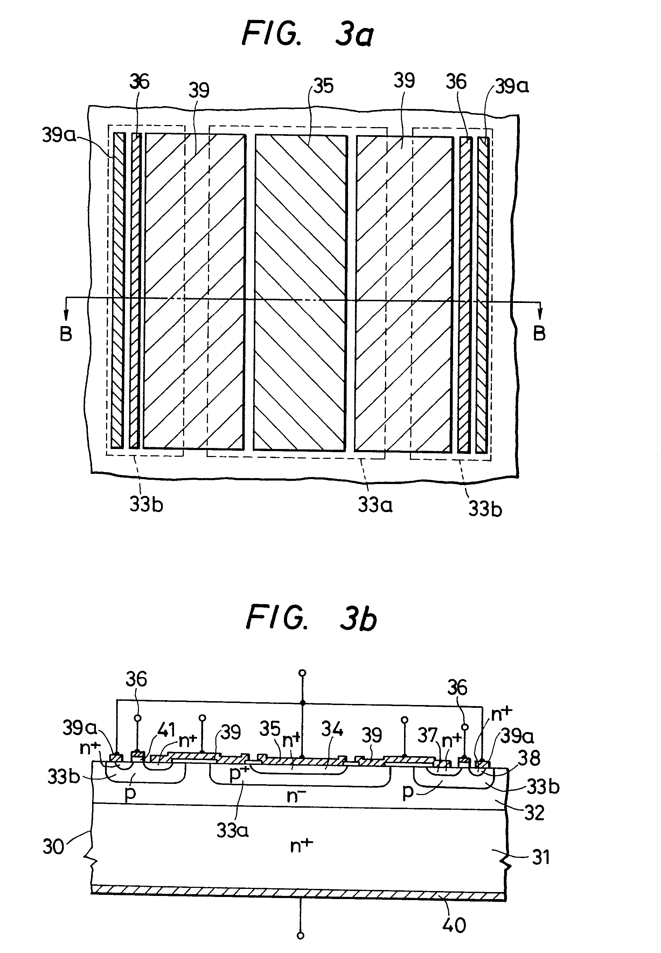

Figs. 3a and 3b show another embodiment of the semiconductor device according to the present invention. Referring to these drawings, the same reference numerals as in Figs. 2a and 2b denote the same or equivalent parts. The construction of the embodiment of Figs. 3a and 3b is different from that of the embodiment of Figs. 2a and 2b in the following points. In the embodiment of Figs. 2a and 2b, the emitter 34 of the bipolar transistor and the drain 37 of the MOS transistor are formed of the same diffusion layer. In the embodiment of Figs. 3a and 3b, such emitter and drain are formed of different diffusion layers 34, 37. Therefore, in the latter embodiment, the base layer 33a in the bipolar transistor is independently formed, and the MOS transistor is formed in the well, i.e. the channel region 33b which is formed simultaneously with the base layer 33a. The emitter layer 34 is divided into a plurality of narrow strips, and MOSFET's are formed on both sides thereof.

In this embodiment, the MOS transistor is formed around the substantially whole circumference of the emitter 34 of the bipolar transistor. Since this transistor has a drain electrode (which serves also as the base electrode of the bipolar transistor) 39 and a gate electrode 36, the concentration of electric current can be prevented.

During the turn-off period, the carriers in the base layer 33a in the bipolar transistor are extracted from the base electrode and put into the emitter electrode 35 through a source electrode 39a which is in ohmic contact with the source 38 and p-well 33b via the MOSFET in the p-well 33b. Accordingly, the bipolar transistor is turned off speedily.

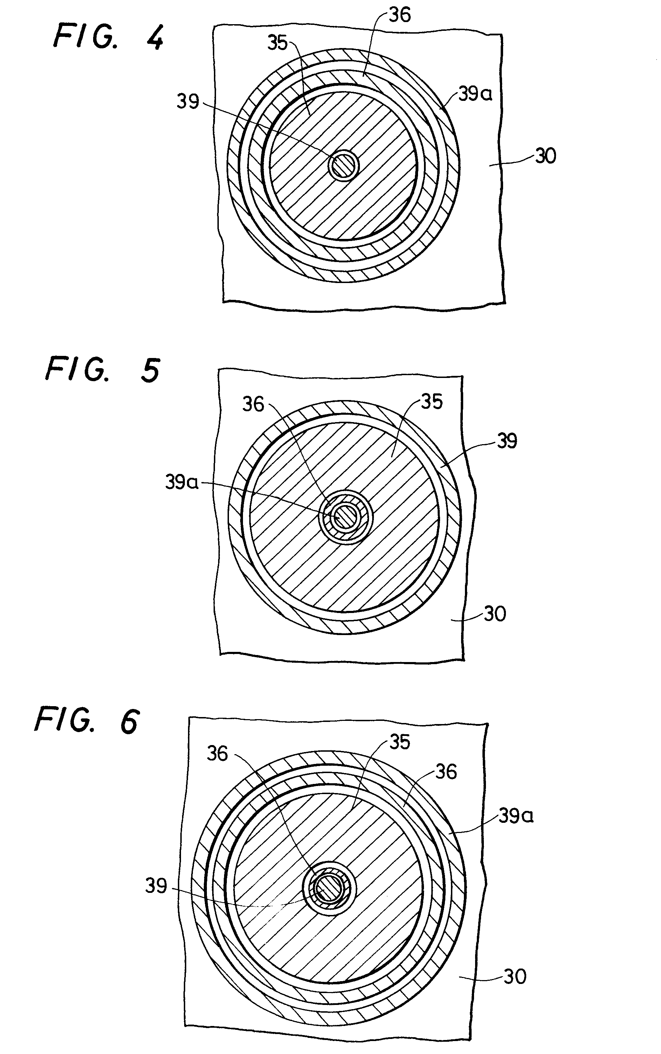

Figs. 4-7 are partial plan views of further embodiments of the semiconductor devices according to the present invention. Referring to these drawings, the same reference numerals as in Figs. 2a-3b denote the same or equivalent parts. In each of these embodiments of figs. 4 - 6, the emitter of the bipolar transistor is in the shape of a ring. In the embodiment of Fig. 4, a base layer is exposed at the central portion of a ring-shaped emitter layer, and a base electrode 39 is in ohmic contact with the base layer. A MOSFET is provided around the outer circumference of the ring-shaped emitter layer.

In the embodiment of Fig. 5, a MOSFET is provided on the inner side of the emitter of a ring-shaped bipolar transistor.

In the embodiment of Fig. 6, the embodiments of Figs. 4 and 5 are combined with each other, i.e., a MOSFET is provided so as to be opposed to both the inner and outer circumferences of a ring-shaped emitter. The embodiments of Figs. 4-6 are illustrated at their parts only, in which a plurality of emitter layers are formed on a semiconductor substrate 30 in accordance with the current capacity.

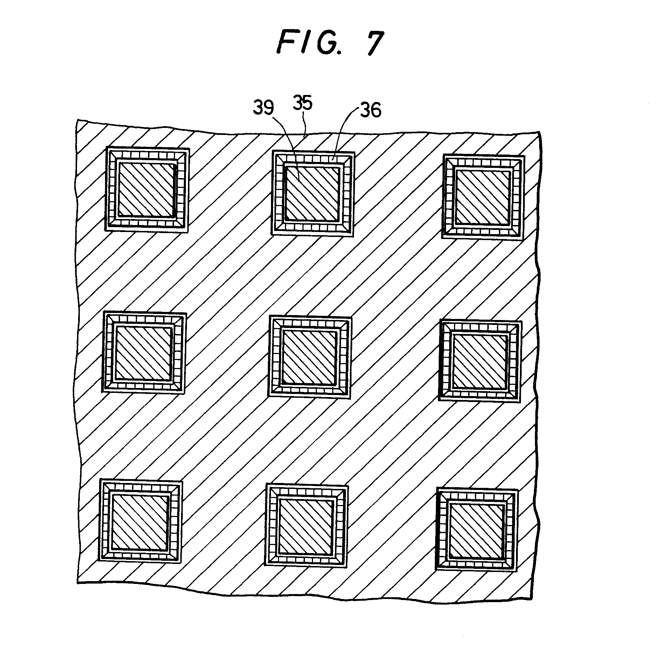

In the embodiment of Fig. 7, the emitters of a bipolar transistor are arranged reticulately or in a checkerboard pattern, and MOSFET's are provided in the hollow spaces therein so that the MOSFET's are opposed to the emitters.

In any of the above-mentioned embodiments, either the drain or the gate of MOS transistor is provided so as to extend near the emitter region of a bipolar transistor and around the substantially whole circumference thereof. Accordingly, the current concentration can be prevented, and the turn-off time can be reduced.

As is clear from the above description, in the semiconductor device according to the present invention, MOSFET is provided so as to be substantially opposed to the emitter of a bipolar transistor with a MOS switch element connected between the base and emitter of the bipolar transistor, so that the semiconductor device has a high voltage resistance, a low ON-resistance and high-speed switching characteristics and can prevent current concentration during the turn-off period.

Even if the conductor types of the semiconductor layers in the above embodiments are all reversed, the same operation and effect can be obtained.  The
illustrations of the embodiments in which only the
conductor types are reversed are omitted.

0180025

Claim:

1. A semiconductor device characterized in that

   (a) a collector layer (31, 32), a base layer (33)
       and an emitter layer (34), the conductor
       types of which are different from each other,
       are formed adjacent to each other so as to
       extend from one main surface of a semiconductor
       substrate (30) to the other main surface thereof,

   (b) said base (33) surrounding said emitter (34)
       and being exposed on the main surface of said
       semiconductor substrate (30),

   (c) source and drain layers (38, 37) of MOSFET
       being provided on a main surface portion of
       said base layer (33), a gate electrode (36)
       being formed on said main surface via an
       insulating film (41) so that said gate
       electrode (36) overlaps both of said source
       and drain layers (38, 37), said source and
       drain layers (38, 37) and said gate electrode
       (36) being provided so as to be substantially
       opposed to said emitter layer (34),

   (d) said drain (37) being connected to said
       emitter layer (34), a base electrode (39)
       being in ohmic contact with said source (38)
       and said base (33),

   (e) a collector electrode (40) and an emitter
       electrode (35) being in ohmic contact with
       said collector (31, 32) and said emitter (34),
       respectively.

2. A semiconductor device according to Claim 1, wherein
   said drain (37) and said emitter (34) are formed
   of a single continuous conductor type layer.

3. A semiconductor device according to Claim 1, wherein said emitter (34) is divided into a plurality of parts each of which is in the shape of a narrow strip.

4. A semiconductor device according to Claim 1, wherein said emitter is in the shape of a ring (Fig. 4-6).

5. A semiconductor device according to Claim 1, wherein said emitter is arranged in a checkerboard pattern, the MOSFET being provided in a base layer which is exposed on one main surface in said checkerboard-like emitter (Fig.7).

6. A semiconductor device according to Claim 1, wherein said base layer is divided into two regions (33a, 33b), one of which is a base region of a bipolar transistor, and the other of which is a channel region of said MOSFET.

7. A semiconductor device according to Claim 6, wherein said drain (37) and said emitter (34) are formed of different diffusion layers.

## FIG. 1a
## PRIOR ART

## FIG. 1b
## PRIOR ART

## FIG. 2a

## FIG. 2b

## FIG. 2c

## FIG. 3a

## FIG. 3b

0180025

FIG. 4

FIG. 5

FIG. 6

## FIG. 7